# EUROPÄISCHE PATENTSCHRIFT

(11) **EP 3 446 373 B1**
(45) Veröffentlichungstag und Bekanntmachung des Hinweises auf die Patenterteilung: **29.09.2021**
(21) Anmeldenummer: 17718013.0
(22) Anmeldetag: 22.03.2017
(51) Int. Cl.: H01R 13/627, H01R 13/629, H01R 13/641

(54) **STECKKONTAKTSET UND VERFAHREN ZUM PRÜFEN EINER VERRASTUNG DES STECKKONTAKTSETS**
PLUG CONTACT AND METHOD FOR TESTING LATCHING MECHANISM OF PLUG CONTACT
UNE FICHE DE CONTACT ET UNE MÉTHODE POUR TESTER LE MÉCANISME DE VERROUILLAGE DE LA FICHE DE CONTACT

(30) Priorität: 18.04.2016 DE 102016107169
(43) Veröffentlichungstag der Anmeldung: 27.02.2019
(73) Patentinhaber: ERNI Production GmbH & Co. KG, 73099 Adelberg (DE)
(72) Erfinder: LAPPÖHN, Jürgen, 73108 Gammelshausen (DE)
(74) Vertreter: Jakelski & Althoff Patentanwälte PartG mbB
(86) Internationale Anmeldenummer: PCT/DE2017/100228
(87) Internationale Veröffentlichungsnummer: WO 2017/182020

(56) Entgegenhaltungen:
- EP-A2- 0 622 870
- DE-A1- 3 906 667
- DE-C- 715 152
- US-A- 4 084 875
- US-A1- 2004 192 092

## Beschreibung

Die vorliegende Erfindung betrifft ein Steckkontaktset umfassend eine Stecckontaktleiste mit mehreren in einem ersten Gehäuse angeordneten ersten Steckkontakten und einen Steckverbinder mit mehreren, in einem zweiten Gehäuse angeordneten zweiten Steckkontakten nach dem Oberbegriff des Anspruchs 1.

### Stand der Technik

Aus der DE 39 06 667 A1 geht ein Steckverbinder mit Sperrmechanismus hervor, der einen Stecker und eine Buchse zur Aufnahme des Steckers umfasst. Es ist ein erster Sperrmechanismus vorgesehen, um den Stecker in einer knappen Einsetzposition zu sperren. Ein zweiter Sperrmechanismus ist vorgesehen, um den Stecker in einer tiefen Einsetzposition zu sperren. Es sind Anzeigeeinrichtungen vorgesehen, um den durch den zweiten Sperrmechanismus bewirkten tiefen Einsetz- beziehungsweise Sperrzustand anzuzeigen, um so den vollständigen Sperrzustand feststellen zu können.

Aus der DE 715 152 A ist eine mit einem Schalter vereinigte Steckdose mit Verriegelung bekannt geworden, bei der ein Einführen oder Herausziehen des Steckers nur im ausgeschalteten Zustand des Schalters möglich ist. Diese Steckdose ist dadurch gekennzeichnet, dass zwecks Verwendung des gleichen Steckers für Steckdosen mit verschieden langem Verriegelungsarm am Stecker zwei oder mehrere Nasen angeordnet sind, von denen jeweils eine Nase mit dem durch den Schalter betätigten Verriegelungsarm in Eingriff kommt.

Aus der EP 0 622 870 A2 geht ein elektrischer Verbinder mit vorgespannter Feder hervor, bei dem an gegenüberliegenden Seiten jeweils erste und zweite Rastelemente vorgesehen sind. Der Stecker weist Steckkontakte unterschiedlicher Länge auf, deren längere bereits im noch nicht verrasteten Zustand der Rastelemente kontaktiert sind, wohingegen die kürzeren Steckkontakte erst kontaktiert sind, wenn die Rastelemente aneinander verrastet sind.

Aus der US 2004/192092 A1 ist ein System zur Vermeidung der Bildung von Lichtbögen in Verbindern, die in ein Netz zur Verteilung von elektrischer Energie eingeschaltet sind, offenbart. Bei diesem System sind bei einem Verbinder zwei Positionen vorgesehen, eine erste Position, bei der alle Kontakte vollständig kontaktiert sind und eine zweite, die so ausgelegt ist, dass hier die Kontakte nicht vollständig kontaktiert sind. In dieser Zwischenposition ist ein Hilfsstromkreis offen und ein Detektionssignal wird erzeugt. Das führt dazu, dass ein Leistungsstrom eines Stromkreislaufs abgeschaltet wird oder anders ausgedrückt, obwohl die Leistungsklemmen fortwährend wechselseitig verbunden sind, fließt durch sie kein elektrischer Strom, sie sind nicht stromführend.

In modernen Kraftfahrzeugen werden in großem Umfang elektrische Verbindungen durch Steckkontaktsets hergestellt, die eine Steckkontaktleiste aufweisen, in die ein Steckverbinder eingesteckt wird. Während des Betriebs des Fahrzeugs unterliegen derartige Steckverbindungen erheblichen Belastungen, beispielsweise Rüttelbelastung, Vibrationsbelastung und dergleichen. Durch diese Belastungen kann es zu einem Herauslösen des Steckverbinders aus der Steckkontaktleiste und damit zu einem Verlust der elektrischen Kontaktierung kommen. Um dies zu verhindern, sind die Gehäuse der Stecckontaktleisten und der Steckverbinder mit Rastelementen versehen. Bei der Montage der Steckverbinder werden diese Rastelemente miteinander verrastet, um eine durch im Kraftfahrzeug auftretende Belastungen nicht lösbare Verbindung zwischen Steckkontaktleiste und Steckverbinder herzustellen.

Durch Montagefehler kann es zu einer sogenannten Halbsteckung eines Steckverbinders in eine Steckkontaktleiste kommen. Hierbei wird zwar ein elektrischer Kontakt zwischen den Steckkontakten der Steckkontaktleiste und Steckkontakten des Steckverbinders hergestellt, es erfolgt jedoch keine Verrastung der Rastelemente. Aufgrund einer räumlich dichten Anordnung von Steckkontaktsets in Kraftfahrzeugen ist eine solche Halbsteckung in der Regel optisch nicht erkennbar. Auch durch eine Messung des Stromflusses zwischen Steckkontaktleiste und Steckverbinder kann eine Halbsteckung nicht detektiert werden, da ein elektrischer Kontakt zwischen Steckverbinder und Steckkontaktleiste besteht, der von der gewünschten Vollsteckung nicht unterscheidbar ist. Erst während des Betriebs des Kraftfahrzeugs kann ein Verlust der elektrischen Kontaktierung zwischen Steckverbinder und Steckkontaktleiste auftreten, welcher dann zwar von der On-Board-Diagnose (OBD) des Kraftfahrzeugs erkannt wird, jedoch erst in einer Werkstatt behoben werden kann. Um eine solche Halbsteckung feststellen zu können, wurde nun vorgeschlagen, mindestens einen Steckkontakt als sogenannten Prüfkontakt mit geringerer Länge als die restlichen Steckkontakte auszubilden. Dieser Prüfkontakt tritt nur in elektrischen Kontakt zu einem korrespondierenden Steckkontakt in dem Steckverbinder, wenn eine vollständige Steckung, also eine Vollsteckung zwischen Steckverbinder und Steckkontaktleiste vorgenommen wurde. Um diese Vollsteckung auch über längere Zeiträume zu gewährleisten, sind erste und zweite Rastelemente vorgesehen, die miteinander verrastet sind, wenn eine solche Vollsteckung vorgenommen wurde. Ein derartiges Steckkontaktset geht beispielsweise aus der EP 0 314 949 A1 hervor. Die ordnungsgemäße Steckung wird dabei dadurch festgestellt, dass geprüft wird, ob ein Bestromen des Prüfkontakts oder des korrespondierenden Steckkontakts in der Steckkontaktleiste in den entsprechenden korrespondierenden Kontakt des Gegenparts, also des Steckverbinders beziehungsweise der Steckkontaktleiste detektiert werden kann. Erst wenn ein Stromfluss detektiert werden kann, kann von einer ordnungsgemäßen Steckung ausgegangen werden.

Diese Steckkontaktsets weisen ein Längsspiel von etwa 0,9 mm bis 1,00 mm auf. Zu Beginn der Steckung, also bei Ausnutzung des maximalen Längsspiels, sind der Steckverbinder und die Steckkontaktleiste durch die ersten und zweiten Rastelemente miteinander verrastet und es sind zwar alle Stecckontakte elektrisch leitend kontaktiert, nicht jedoch der Prüfkontakt. Das Längsspiel ist erforderlich, um Toleranzen des Messerkontaktelements und des Federkontaktelements, die den Prüfkontakt bilden, auszugleichen. Während der Montage werden die Steckverbinder auf die Steckkontaktleisten geschoben. Dabei ist es erforderlich, dass die Steckverbinder bis auf den Grund der Steckkontaktleiste geschoben werden. In diesem Falle sind alle Stecckontakte und auch der Prüfkontakt elektrisch korrekt kontaktiert. Unter elektrisch "korrekt kontaktiert" wird vorliegend nicht nur eine zufällige Berührung der beiden Kontaktelemente, zum Bespiel der Spitze eines Messerkontaktelements und des Federkontaktelements, verstanden, sondern eine vollständige Kontaktierung, beispielsweise durch vollständiges Ineinanderschieben der Messerkontaktelemente in die Federkontaktelemente. Nun kann während der Montage der Fall eintreten, dass sich ein Steckverbinder innerhalb des Längsspiels wieder etwas aus der Steckkontaktleiste herauslöst, weil beispielsweise an den Kabeln gezogen wurde, die zu den Steckverbindern führen, oder dergleichen. Dieser Fall kann insbesondere auch noch nach einer ordnungsgemäßen Steckung des Steckverbinders auftreten. Wenn dabei der Steckverbinder soweit aus der Steckkontaktleiste herausgelöst wurde, dass das Längsspiel voll ausgenutzt wurde, tritt der Fall ein, dass der Prüfkontakt des Steckverbinders nicht mehr mit der den entsprechenden Stecckontakten der Steckkontaktleiste elektrisch leitend verbunden ist. In diesem Falle wird ein oben beschriebener Defekt signalisiert, der als sogenannter Psyeudofehler während der Fertigung bezeichnet wird. "Psyeudofehler" deshalb, weil eigentlich gar kein Fehler vorliegt, denn die Steckkontakte, also die Nutzkontakte sind in diesem Falle alle korrekt kontaktiert, mit Ausnahme des Prüfkontaktes. Während der Montage wird dies allerdings als Fehler festgestellt. Ein solcher Fehler ist deshalb besonders störend und nachteilig, weil auch bei einer Inaugenscheinnahme der Steckkontaktsets eine ordnungsgemäße Steckung erkennbar ist, da ja die Rastelemente miteinander verrastet sind. Eine solche Fehlkontaktierung ist bei der Montage besonders störend, da während des Montageprozesses Fehlkontaktierungen signalisiert werden, die den Montageprozess verzögern.

### Offenbarung der Erfindung

Bei dem erfindungsgemäßen Steckkontaktset sind daher jeweils zwei an gegenüberliegenden Seitenwänden des ersten Gehäuses erste Rastelemente und jeweils zwei an gegenüberliegenden Seitenwänden des zweiten Gehäuses zweite und dritte Rastelemente angeordnet und die dritten Rastelemente sind mit den ersten Rastelementen verrastbar in Steckrichtung von den zweiten Rastelementen so beabstandet angeordnet, dass durch eine Verrastung der dritten Rastelemente mit den ersten Rastelementen eine möglichst spielfreie Fixierung des zweiten Gehäuseteils an dem ersten Gehäuseteil im vollständig kontaktierten Zustand der ersten und zweiten Steckkontakte erzielt wird, wobei das Steckkontaktset einen ersten Rastpunkt, einen zweiten Rastpunkt und einen dritten Rastpunkt aufweist, wobei die ersten Rastelemente in allen drei Rastpunkten mit den zweiten Rastelementen verrastet sind und wobei in dem ersten Rastpunkt kein zweiter Steckkontakt mit einem Prüfkontakt elektrisch in Kontakt tritt, in dem zweiten Rastpunkt wenigstens ein zweiter Steckkontakt mit dem Prüfkontakt in elektrischen Kontakt tritt und in dem dritten Rastpunkt alle ersten und zweiten Steckkontakte miteinander in Kontakt getreten sind und die beiden Gehäuseteile aneinander fixiert sind.

Der zweite Rastpunkt ist also der Rastpunkt, der gewöhnlich eine ordnungsgemäße Steckung repräsentiert. Der dritte Rastpunkt entspricht dem zweiten Rastpunkt, jedoch ist hier absolut sichergestellt, dass alle Steckkontakte miteinander kontaktiert sind und dass die beiden Gehäuseteile nahezu spielfrei fixiert sind.

Durch das dritte Rastelement, welches ebenfalls mit dem ersten Rastelement verrastbar ist und welches durch die Verrastung eine möglichst spielfreie Fixierung des zweiten Gehäuseteils in dem ersten Gehäuseteil im vollständig kontaktierten Zustand der ersten und zweiten Steckkontakte ermöglicht, wird während des Montagevorgangs eine sichere Kontaktierung des Prüfkontakts mit dem korrespondierenden Steckkontakt sichergestellt und so Fehlermeldungen aufgrund des vorerwähnten Spiels, welche zu einer NichtKontaktierung des Prüfkontakts führen können, vermieden. Darüber hinaus wird wirkungsvoll ein Herauslösen des zweiten Gehäuseteils aus dem ersten Gehäuseteil, also ein Herauslösen des Steckverbinders aus der Steckkontaktleiste während des Betriebs beispielsweise eines Fahrzeugs verhindert. Durch dieses dritte Rastelement wird außerdem sichergestellt, dass der Steckverbinder vollständig in die Steckkontaktleiste gesteckt ist und in diesem Zustand verharrt. Ein "Nachstecken" des Steckverbinders ist auf diese Weise nicht mehr erforderlich. Ein solches Nachstecken ist beispielsweise bei den aus dem Stand der Technik bekannten Steckverbindern immer dann erforderlich, wenn eine Stromunterbrechung an dem Prüfkontakt festgestellt wurde. Der erste und einfache Weg der Prüfung, ob ein Defekt vorliegt, ist es dann, den Steckverbinder noch einmal etwas fester in die Steckkontaktleiste zu drücken, was durch einen Monteur während der Montage geschehen muss. Insbesondere bei sehr vielen zu montierenden Steckverbindern kann ein solcher zusätzlicher Montagevorgang sehr nachteilig sein. Durch die erfindungsgemäße Lösung wird ermöglicht, dass bei Einrasten des dritten Rastelements in das erste Rastelement sichergestellt ist, dass eine vollständige Steckung der Steckkontakte vorliegt und dass das erste und zweite Gehäuse miteinander so verbunden sind, dass auch Rüttelbelastungen und andere mechanische Belastungen nicht zu einer Dekontaktierung der Steckkontakte führen können.

Die Ausbildung der Rastelemente an gegenüberliegenden Seitenwänden stellt eine parallele und gleichmäßige Steckung des Steckverbinders in die Steckkontaktleiste und damit eine vollständige Kontaktierung der Steckkontakte sicher.

Die Rastelemente können rein prinzipiell auf unterschiedliche Art und Weise ausgebildet werden. Gemäß einer vorteilhaften Ausgestaltung ist vorgesehen, dass die ersten Rastelemente Rastöffnungen sind und die zweiten Rastelemente und die dritten Rastelemente an die Rastöffnungen angepasste Rastnasen sind. Diese Ausgestaltung der Rastelemente kann auf einfache Weise hergestellt werden und sie ermöglicht gleichzeitig eine sehr gute Verrastung der beiden Gehäuseteile aneinander.

Dabei ist vorteilhafterweise vorgesehen, dass die dritten Rastelemente an einer die Rastöffnungen begrenzenden Wand unter Ausübung einer Vorspannung anliegen. Durch diese Vorspannung wird eine mechanischen Belastungen und insbesondere Rüttelbelastungen standhaltende Fixierung der beiden Gehäuseteile des Steckverbinders und der Steckkontaktleiste aneinander erreicht.

Rein prinzipiell könnte insbesondere bei sehr langen Steckkontaktleisten mit sehr vielen Steckkontakten mehr als ein Prüfkontakt vorgesehen sein. Eine vorteilhafte Ausführungsform sieht genau einen Prüfkontakt vor. Bereits mit einem Prüfkontakt kann eine ordnungsgemäße Steckung überprüft werden. Die restlichen Steckkontakte können dabei anderen Zwecken zur Verfügung stehen.

Bevorzugterweise ist vorgesehen, dass dieser Prüfkontakt mittig in der Kontaktleiste angeordnet ist. Durch diese Anordnung wird wiederum festgestellt, ob eine gleichmäßige, also insbesondere nicht verkantete oder schräge, sondern parallele Steckung des Steckverbinders in die Kontaktleiste vorgenommen wurde. Nur in diesem Falle tritt keine Stromunterbrechung auf.

Der Prüfkontakt weist - wie bereits vorstehend erwähnt - eine geringere Länge als die anderen Steckkontakte in der Steckkontaktleiste auf. Die restlichen Steckkontakte weisen dagegen im Wesentlichen dieselbe Länge auf.

Dabei ist der Prüfkontakt so kurz ausgebildet, dass er nicht in elektrischen Kontakt mit einem zweiten Steckkontakt tritt, wenn das wenigstens eine erste Rastelement nicht mit dem wenigstens einen zweiten Rastelement verrastet ist. Hierdurch wird festgestellt, ob der Stecker ordnungsgemäß gesteckt wurde.

### Kurze Beschreibung der Zeichnungen

Ein Ausführungsbeispiel der Erfindung ist in den Zeichnungen dargestellt und in der nachfolgenden Beschreibung näher erläutert.
Fig. 1 zeigt eine schematische Darstellung eines erfindungsgemäßen Stecckontaktsets im nicht gesteckten Zustand mit einer Ausschnittsvergrößerung der Steckkontakte bzw. des Prüfkontaktes;
Fig. 2 zeigt das in Fig. 1 dargestellte Steckkontaktset im gesteckten Zustand mit einer Ausschnittvergrößerung der Rastelemente;
Fig. 3 zeigt das in Fig. 1 und 2 dargestellte Steckkontaktset im vollständig verrasteten Zustand mit einer Ausschnittvergrößerung der Rastelemente;
Fig. 4a) zeigt eine Schnittdarstellung entlang der Linie A-A in Fig. 2;
Fig. 4b) zeigt eine Schnittdarstellung entlang der Linie B-B in Fig. 2 mit einer Ausschnittvergrößerung des Prüfkontakts;
Fig. 4c) zeigt eine Schnittdarstellung entlang der Linie C-C in Fig. 3;
Fig. 4d) zeigt eine Schnittdarstellung entlang der Linie D-D in Fig. 3 mit einer Ausschnittvergrößerung des Prüfkontakts im gesteckten Zustand;

### Ausführungsbeispiele der Erfindung

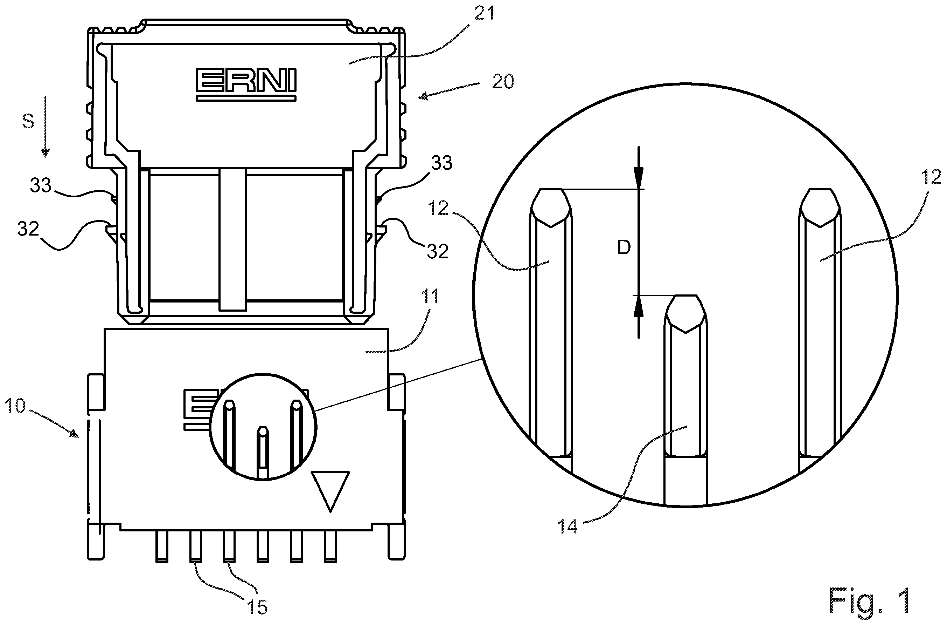

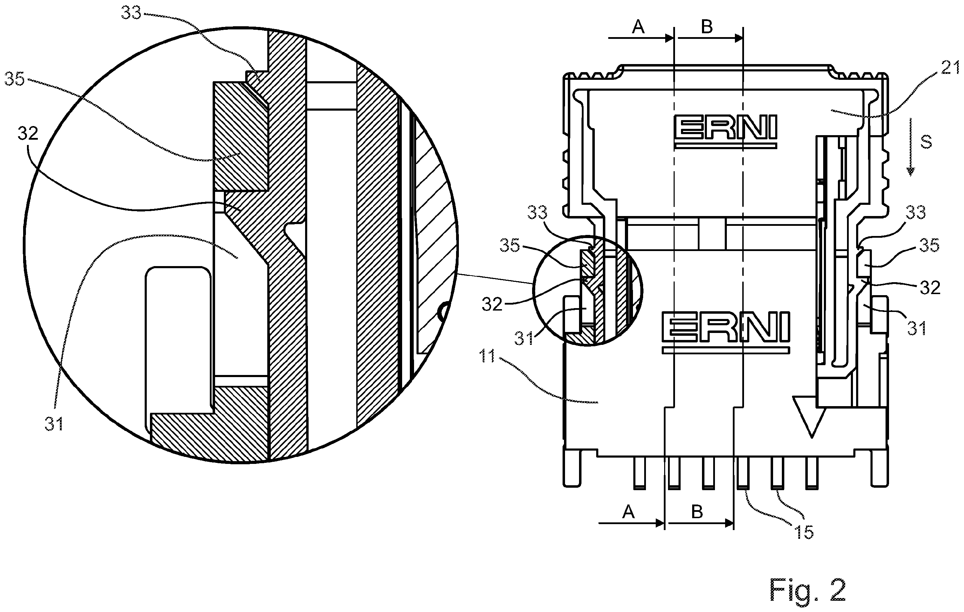

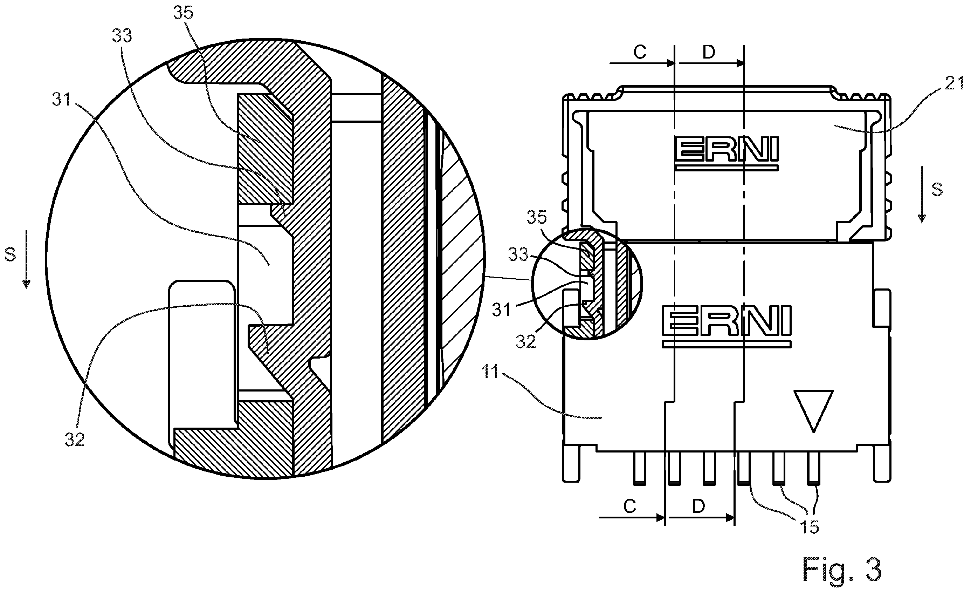

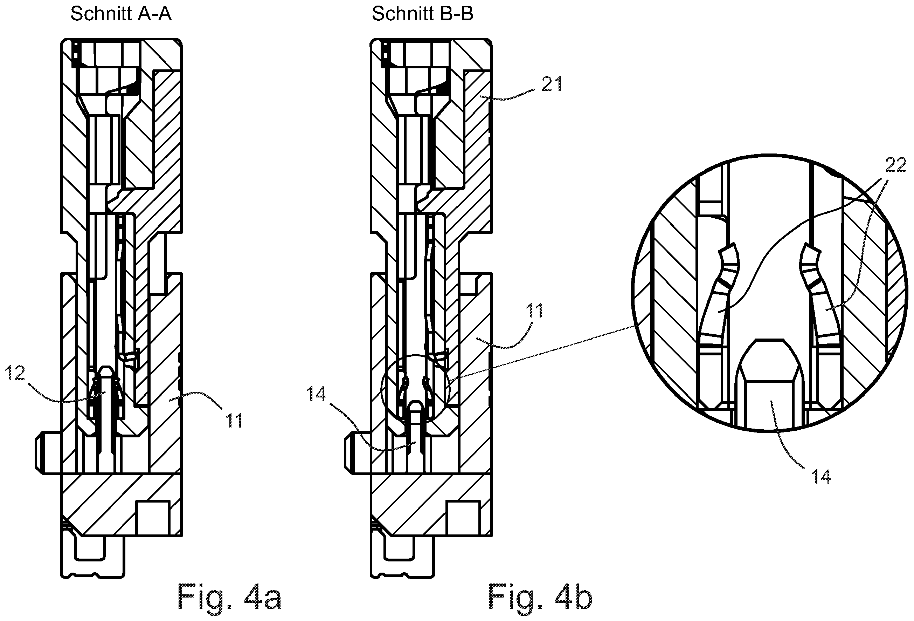

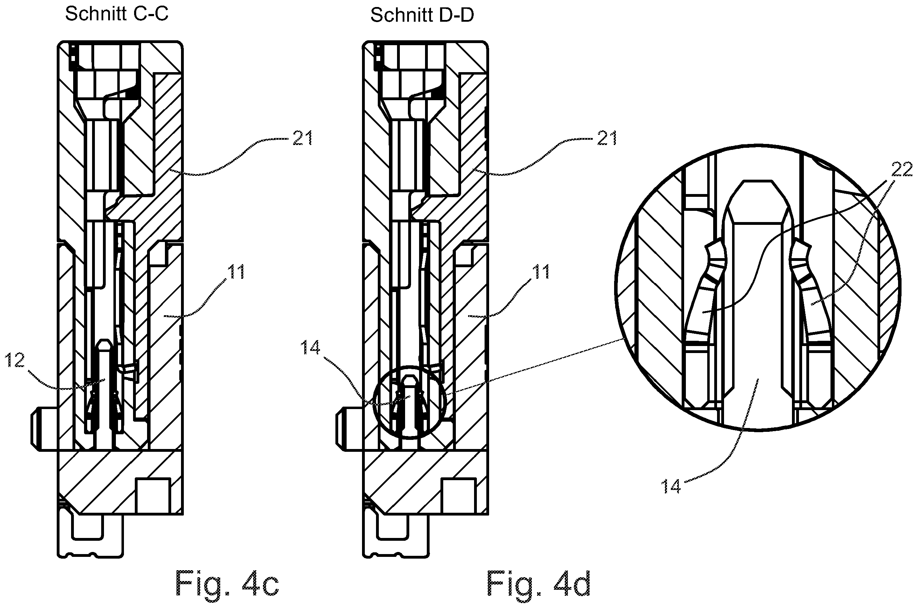

In den Figuren 1, 2, und 3 ist jeweils ein Steckkontaktset in unterschiedlich gesteckten Zuständen dargestellt. Das Steckkontaktset umfasst eine Stecckontaktleiste 10 und einen Steckverbinder 20, die ineinander steckbar sind. Die Steckkontaktleiste 10 weist ein erstes Gehäuse 11 auf, der Steckverbinder 20 weist ein zweites Gehäuse 21 auf. In dem ersten Gehäuse 11 ist eine Mehrzahl von ersten Steckkontakten 12 von im Wesentlichen gleicher Länge auf an sich bekannte Weise nebeneinanderliegend in Form von einer oder mehreren Reihen angeordnet. Ein erster Steckkontakt 14 ist kürzer ausgebildet um eine Länge Δ, wie aus der Ausschnittvergrößerung der Fig. 1 hervorgeht. Dieser kürzer ausgebildete Steckkontakt 14 ist ein Prüfkontakt. Alle Steckkontakte weisen auf ihrer der Steckseite abgewandten, einer (nicht dargestellten) Leiterplatte zugewandten Seite Anschlusspins 15 auf. In dem zweiten Gehäuse 21 sind an sich bekannte Federkontaktelemente ebenfalls in einer oder mehreren Reihen nebeneinanderliegend angeordnet, welche an die Messerkontakte 12, 14 angepasst sind. Solche Federkontakte 22 sind in den Figuren 4a bis 4d dargestellt. Im ineinandergesteckten Zustand des Steckverbinders 20 in der Steckkontaktleiste 10 sind alle Messerkontakte 12, 14 mit allen Federkontakten 22 elektrisch kontaktiert. Um festzustellen, ob eine ordnungsgemäße Kontaktierung vorliegt, wird der Prüfkontakt 14 oder alternativ der mit dem Prüfkontakt 14 korrespondierende Messerkontakt bestromt und festgestellt, ob ein Stromfluss zwischen dem Prüfkontakt 14 zu dem korrespondierenden Federkontakt 22 oder umgekehrt von dem korrespondierenden Federkontakt 22 zu dem Prüfkontakt 14 vorliegt. Wenn dies der Fall ist, wird von einer ordnungsgemäßen Steckung ausgegangen. Wenn dies nicht der Fall ist, liegt eine Kontaktunterbrechung vor zwischen Prüfkontakt 14 und korrespondierendem zweiten Steckkontakt in Form eines Federkontakts 22. In diesem Falle muss von einer Halbsteckung oder nicht ordnungsgemäßen Steckung ausgegangen werden. Eine solche nicht ordnungsgemäße Steckung oder auch Halbsteckung kann als erster Rastpunkt bezeichnet werden. In einem zweiten Rastpunkt ist eine vollständige Steckung erreicht. In diesem Falle sind ein zweites Rastelement 32 mit einem ersten Rastelement 31 verrastet. Das zweite Rastelement 32 kann wie aus den Ausschnittvergrößerungen der Fig. 2 und 3 hervorgeht, beispielsweise eine Rastnase sein, die in einer korrespondierenden Rastöffnung 31 angeordnet ist. Dabei liegt das zweite Rastelement 32 an einer die Rastöffnung 31 begrenzenden Wand eines Steges 35, der an der Steckerkontaktleiste 10 angeordnet ist, an. Dies ist in der Ausschnittvergrößerung in Fig. 2 im Schnitt dargestellt. Nun ist vorgesehen, dass die Rastöffnung 31 ein gewisses Spiel in Steckrichtung S zulässt, was dadurch erreicht wird, dass die Rastöffnung 31 in Steckrichtung S eine gewisse Länge aufweist, die ein Bewegen des zweiten Rastelements 32, also der Rastnase in und entgegen der Steckrichtung S ermöglicht. Dieses Spiel beträgt etwa 0,9 mm bis 1,0 mm. Es ist dem Funktionsablauf während des Steckvorgangs im Zusammenhang mit dem Prüfkontakt geschuldet. Zunächst findet eine Verrastung der ersten und zweiten Rastelemente statt. Diese Verrastung muss um den erwähnten Betrag, also zwischen 0,9 mm und 1,0 mm vor der Endlage (völlig gesteckter Zustand) erfolgen, um sicherzustellen, dass zwar alle Nutzkontakte, also alle Steckkontakte 12 sicher eingerastet sind, nicht jedoch der kürzere Prüfkontakt 14, der in dieser Steckposition auf keinen Fall schon eine Berührung mit dem korrespondierenden Federkontakt 22 in dem Steckverbinder 20, also einer Kontaktfeder aufweisen darf. Während der Montage wird nun der Steckverbinder 20 vollständig auf die Steckerkontaktleiste 10 geschoben. Bei vollständigem Schieben des Steckverbinders 20 auf die Steckerkontaktleiste 10 auf den Grund, also gewissermaßen bis zum Anschlag, sind alle Stecckontakte 12 und auch der Prüfkontakt 14 mit den entsprechenden korrespondierenden Federkontakten 22 elektrisch leitend verbunden, also kontaktiert. Nun kann während der Montage der unerwünschte Fall auftreten, dass an dem Steckverbinder und/oder an den Kabeln, die zu ihm führen gezogen wird, sodass sich der Steckverbinder 20 etwas aus der Steckkontaktleiste 12 herauslöst. Das Herauslösen findet also nach einer anfänglich ordnungsgemäßen Steckung statt. Auch könnte der Fall eintreten, dass es während der Montage des Steckverbinders 20 an der Steckkontaktleiste 10 zwar zu einer Verrastung des Rastelements 32 in der Rastöffnung 31 kommt, dass der Steckverbinder 20 aber nicht so tief gesteckt ist, dass der Prüfkontakt 14 und der entsprechende korrespondierte Federkontakt 22 miteinander in elektrisch leitender Verbindung stehen. Diese Steckung wird während der Montage als Störung festgestellt und signalisiert. Hier handelt es sich zwar um einen Psyeudofehler, der auch als solcher bezeichnet wird, denn die Steckkontakte 12 der Steckkontaktleiste 10 und des Steckverbinders 20 sind - bis auf den Prüfkontakt 14 - korrekt kontaktiert. Während der Montage wird allerdings eine Nichtkontaktierung des Prüfkontakts 14 als Fehler erkannt. In diesem Fall müsste ein Monteur den Steckverbinder 20 wieder ganz in die Steckkontaktleiste 10 durch Ausüben eines entsprechenden Drucks in Steckrichtung S hineindrücken. Es versteht sich, dass insbesondere bei einer sehr großen Zahl von derartigen Steckkontaktsets, wie sie beispielsweise in Fahrzeugen verbaut werden, ein derartiges "Nachstecken" zeitaufwendig und für die Montage von Fahrzeugen am Fließband nicht erwünscht ist.

Um dies zu vermeiden, sieht die Erfindung ein drittes Rastelement 33 in Form einer weiteren Rastnase vor. Im vollständig gesteckten Zustand, also dann, wenn der Steckverbinder 20 vollständig auf den Grund der Steckkontaktleiste10 gesteckt ist und alle Steckkontakte 12, 14, 22 miteinander elektrisch verbunden sind, rastet das dritte Rastelement 33 in der Rastöffnung 31, also in dem ersten Rastelement ein und liegt an der die Öffnung 31 begrenzenden Wand des Steges 35 an, sodass die beiden Gehäuseteile 11, 21 möglichst spielfrei aneinander fixiert sind. Dieser Zustand ist in Fig. 3 und insbesondere in der Ausschnittvergrößerung dargestellt.

Das dritte Rastelement 33 ermöglicht also eine Fixierung im Zustand der Vollsteckung, das heißt in einem dritten Rastpunkt, der sich von dem zweiten Rastpunkt, der in Fig. 2 dargestellt ist, dadurch unterscheidet, dass während der Montage sichergestellt ist, dass die Steckkontaktsets vollständig gesteckt sind, was durch Feststellung eines gesteckten Prüfkontakts 14 erfasst werden kann. Dabei sind die beiden Gehäuseteile so aneinander fixiert, dass auch eine Rüttelbelastung oder eine andere mechanische Belastung, beispielsweise eine Vibrationsbelastung oder dergleichen kein Herauslösen des Steckverbinders 20 aus der Steckkontaktleiste 10 zulässt.

Eine ordnungsgemäße Steckung kann festgestellt werden, indem entweder der Prüfkontakt 14 oder sein korrespondierender Federkontakt 22 im Steckverbinder 20 bestromt wird. Dabei wird geprüft, ob ein Strom zwischen dem Prüfkontakt 14 und dem entsprechenden Steckkontakt 22 fließt. Ist dies nicht der Fall, so liegt keine ordnungsgemäße Steckung vor. Dies ermöglicht eine automatisierte Prüfung von erfindungsgemäßen Steckkontaktsets auf das Vorliegen einer beispielsweise Halbsteckung oder nicht ordnungsgemäßen Steckung. Wird eine solche erkannt, so kann die Halbsteckung oder die nicht ordnungsgemäße Steckung noch im Montageprozess korrigiert werden.

## Patentansprüche

1. Steckkontaktset, umfassend eine Steckkontaktleiste (10) mit mehreren in einem ersten Gehäuse (11) angeordneten ersten Steckkontakten (12, 14), deren mindestens einer als Prüfkontakt (14) mit geringerer Länge als die restlichen Steckkontakte (12) ausgebildet ist, und einen Steckverbinder (20) mit mehreren, in einem zweiten Gehäuse (21) angeordneten zweiten Steckkontakten (22), deren mindestens einer eingerichtet ist, mit dem mindestens einen Prüfkontakt (14) in elektrischen Kontakt zu treten, wobei das erste Gehäuse (11) wenigstens ein erstes Rastelement (31) und das zweite Gehäuse (21) wenigstens ein zweites Rastelement (32) aufweisen, die eingerichtet sind, aneinander zu verrasten, wobei jeweils zwei an gegenüberliegenden Seitenwänden des ersten Gehäuses (11) angeordnete erste Rastelemente (31) und jeweils zwei an gegenüberliegenden Seitenwänden des zweiten Gehäuses (21) angeordnete zweite und dritte Rastelemente (32, 33) vorhanden sind, und dass die dritten Rastelemente mit den ersten Rastelementen (31) verrastbar und in Steckrichtung (S) von den zweiten Rastelementen (32) so beabstandet angeordnet sind, dass durch eine Verrastung der dritten Rastelemente (33) mit den ersten Rastelementen (31) eine möglichst spielfreie Fixierung des zweiten Gehäuseteils (21) an dem ersten Gehäuseteil (11) im vollständig kontaktierten Zustand der ersten und zweiten Steckkontakte (12, 14; 22) erzielt wird, **dadurch gekennzeichnet, dass** das Steckkontaktset einen ersten Rastpunkt, einen zweiten Rastpunkt und einen dritten Rastpunkt aufweist, wobei die ersten Rastelemente (31) in allen drei Rastpunkten mit den zweiten Rastelementen (32) verrastet sind und wobei in dem ersten Rastpunkt kein zweiter Steckkontakt (22) mit einem Prüfkontakt (14) elektrisch in Kontakt tritt, in dem zweiten Rastpunkt wenigstens ein zweiter Steckkontakt (22) mit einem Prüfkontakt (14) in elektrischen Kontakt tritt und in dem dritten Rastpunkt alle ersten und zweiten Steckkontakte (12, 14; 22) miteinander in Kontakt getreten sind und die beiden Gehäuseteile (11, 21) aneinander fixiert sind.

2. Steckkontaktset nach Anspruch 1, **dadurch gekennzeichnet, dass** die ersten Rastelemente Rastöffnungen (31) sind und dass die zweiten Rastelemente (32) und die dritten Rastelemente (33) an die Rastöffnungen (31) angepasste Rastnasen sind.

3. Steckkontaktset nach Anspruch 2, **dadurch gekennzeichnet, dass** die dritten Rastelemente (33) an einer die Rastöffnungen (31) begrenzenden Wand möglichst spielfrei anliegen.

4. Steckkontaktset nach Anspruch 1, **dadurch gekennzeichnet, dass** die Steckkontaktleiste (10) genau einen Prüfkontakt (14) aufweist.

5. Steckkontaktset nach Anspruch 4, **dadurch gekennzeichnet, dass** der Prüfkontakt (14) mittig in der Steckkontaktleiste (10) angeordnet ist.

6. Steckkontaktset nach Anspruch 4 oder 5, **dadurch gekennzeichnet, dass** alle restlichen ersten Steckkontakte (12) dieselbe Länge aufweisen.

7. Steckkontaktset nach Anspruch 1, **dadurch gekennzeichnet, dass** die zweiten Steckkontakte (22) alle dieselbe Länge aufweisen.

8. Steckkontaktset nach einem der vorstehenden Ansprüche, **dadurch gekennzeichnet, dass** der Prüfkontakt (14) so kurz ausgebildet ist, dass er nicht in elektrischen Kontakt mit einem zweiten Steckkontakt (22) tritt, wenn das wenigstens eine erste Rastelement (31) nicht mit dem wenigstens einen zweiten Rastelement (32) verrastet ist.

9. Steckkontaktset nach einem der vorstehenden Ansprüche, **dadurch gekennzeichnet, dass** die ersten Steckkontakte (12) Messerkontaktelemente sind und dass die zweiten Steckkontakte (22) Federkontaktelemente sind.

## Claims

1. Plug contact set, comprising a plug contact strip (10) having several first plug contacts (12, 14) arranged in a first housing (11), at least one of which is formed as a checking contact (14) having a shorter length than the rest of the plug contacts (12), and a plug connecter (20) having several second plug contacts (22) arranged in a second housing (21), at least one of which is configured to come into electrical contact with the at least one checking contact (14), wherein the first housing (11) has at least one first latch element (31) and the second housing (21) has at least one second latch element (32), which are configured to latch together,
wherein
two respective first latch elements (31) arranged on opposite side walls of the first housing (11) and two respective second and third latch elements (32, 33) arranged on opposite side walls of the second housing (21) are provided, and that the third latch elements (33) can be latched with the first latch elements (31) and are arranged to be spaced apart from the second latch elements (32) in the plugging direction (S) in such a way that, by latching the third latch elements (33) with the first latch elements (31), an as clearance-free as possible fixing of the second housing part (21) on the first housing part (11) in the completely contacted state of the first and second plug contacts (12, 14; 22) is achieved, **characterised in that** the plug contact set has a first latch point, a second latch point and a third latch point, wherein the first latch elements (31) are latched to the second latch elements (32) at all three latch points and wherein, in the first latch point, no second plug contact (22) comes into electrical contact with a checking contact (14), in the second latch point, at least one second plug contact (22) comes into electrical contact with a checking contact (14) and, in the third latch point, all first and second plug contacts (12, 14; 22) have come into contact with one another and the two housing parts (11, 21) are fixed to one other.

2. Plug contact set according to claim 1, **characterised in that** the first latch elements are latch openings (31) and that the second latch elements (32) and the third latch elements (33) are latch noses adapted to the latch openings (31).

3. Plug contact set according to claim 2, **characterised in that** the third latch elements (33) rests against a wall which delimits the latch openings (31) as clearance-free as possible.

4. Plug contact set according to claim 1, **characterised in that** the plug contact strip (10) has exactly one checking contact (14).

5. Plug contact set according to claim 4, **characterised in that** the checking contact (14) is arranged centrally in the plug contact strip (10).

6. Plug contact set according to claim 4 or 5, **characterised in that** all remaining first plug contacts (12) have the same length.

7. Plug contact set according to claim 1, **characterised in that** the second plug contacts (22) are all of the same length.

8. Plug contact set according to one of the preceding claims, **characterised in that** the checking contact (14) is formed to be so short that it does not come into electrical contact with a second plug contact (22) when the at least one first latch element (31) is not latched with the at least one second latch element (32).

9. Plug contact set according to one of the preceding claims, **characterised in that** the first plug contacts (12) are blade contact elements and the second plug contacts (22) are spring contact elements.

## Revendications

1. Ensemble de contacts enfichables, comprenant : une barrette à contacts enfichables (10) présentant plusieurs premiers contacts enfichables (12, 14) disposés dans un premier boîtier (11) et dont au moins un, de longueur inférieure à celle des autres contacts enfichables (12), sert de contact de test (14) ; et un connecteur (20) présentant plusieurs deuxièmes contacts enfichables (22) disposés dans un deuxième boîtier (21) et dont au moins un est configuré à entrer en contact électrique avec l'au moins un contact de test (14), ledit premier boîtier (11) présentant au moins un premier élément d'encliquetage (31) et ledit deuxième boîtier (21) au moins un deuxième élément d'encliquetage (32) configurés à s'encliqueter l'un avec l'autre ;
dans lequel ensemble
il est prévu deux premiers éléments d'encliquetage (31), chacun disposé sur une des parois latérales opposées du premier boîtier (11), et deux deuxièmes et troisièmes éléments d'encliquetage (32, 33), chacun disposé sur une des parois latérales opposées du deuxième boîtier (21), lesquels troisièmes éléments d'encliquetage peuvent s'encliqueter avec les premiers éléments d'encliquetage (31) et sont disposés à une distance des deuxièmes éléments d'encliquetage (32), dans le sens de l'enfichage (S), qui est telle qu'un encliquetage des troisièmes éléments d'encliquetage (33) avec les premiers éléments d'encliquetage (31) entraîne une fixation, avec le moins de jeu possible, de la deuxième partie de boîtier (21) à la première partie de boîtier (11) à l'état de contact total des premiers et deuxièmes contacts enfichables (12, 14 ; 22) ; **caractérisé en ce que** l'ensemble de contacts enfichables présente un premier point d'encliquetage, un deuxième point d'encliquetage et un troisième point d'encliquetage, étant entendu que, auxdits trois points d'encliquetage, les premiers éléments d'encliquetage (31) sont encliquetés avec les deuxièmes éléments d'encliquetage (32), et étant entendu qu'aucun deuxième contact enfichable (22) n'entre en contact électrique avec un contact de test (14) au premier point d'encliquetage, au moins un deuxième contact enfichable (22) entre en contact électrique avec un contact de test (14) au deuxième point d'encliquetage, et les premiers et deuxièmes contacts enfichables (12, 14 ; 22) sont tous en contact entre eux et les deux parties de boîtier (11, 21) sont fixées l'une à l'autre au troisième point d'encliquetage.

2. Ensemble de contacts enfichables selon la revendication 1, **caractérisé en ce que** les premiers éléments d'encliquetage sont des ouvertures d'encliquetage (31) et **en ce que** les deuxièmes éléments d'encliquetage (32) et les troisièmes éléments d'encliquetage (33) sont des ergots d'encliquetage adaptés aux ouvertures d'encliquetage (31).

3. Ensemble de contacts enfichables selon la revendication 2, **caractérisé en ce que** les troisièmes éléments d'encliquetage (33) jouxtent une paroi délimitant les ouvertures d'encliquetage (31) avec le moins de jeu possible.

4. Ensemble de contacts enfichables selon la revendication 1, **caractérisé en ce que** la barrette à contacts enfichables (10) présente exactement un contact de test (14).

5. Ensemble de contacts enfichables selon la revendication 4, **caractérisé en ce que** le contact de test (14) est disposé au centre de dans la barrette à contacts enfichables (10).

6. Ensemble de contacts enfichables selon la revendication 4 ou 5, **caractérisé en ce que** tous les autres premiers contacts enfichables (12) présentent la même longueur.

7. Ensemble de contacts enfichables selon la revendication 1, **caractérisé en ce que** les deuxièmes contacts enfichables (22) présentent tous la même longueur.

8. Ensemble de contacts enfichables selon l'une des revendications précédentes, **caractérisé en ce que** le contact de test (14) est conçu de courte taille, ne lui permettant pas d'entrer en contact électrique avec un deuxième contact enfichable (22) lorsque l'au moins un premier élément d'encliquetage (31) n'est pas encliqueté avec l'au moins un deuxième élément d'encliquetage (32).

9. Ensemble de contacts enfichables selon l'une des revendications précédentes, **caractérisé en ce que** les premiers contacts enfichables (12) sont des éléments de contact à lame et **en ce que** les deuxièmes contacts enfichables (22) sont des éléments de contact à ressort.
